(19)

Europäisches
Patentamt
European
Patent Office
Office européen
des brevets

(11) **EP 2 009 692 A1**

(12) **EUROPEAN PATENT APPLICATION**

(43) Date of publication:
**31.12.2008 Bulletin 2009/01**

(51) Int Cl.:
*H01L 23/552* (2006.01)  *H01L 25/04* (2006.01)

(21) Application number: **08011741.9**

(22) Date of filing: **27.06.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **29.06.2007 JP 2007172088
11.06.2008 JP 2008153261**

(71) Applicant: **TDK Corporation
Tokyo 103-8272 (JP)**

(72) Inventor: **Asami, Shigeru
Tokyo 103-8272 (JP)**

(74) Representative: **Grünecker, Kinkeldey,
Stockmair & Schwanhäusser
Anwaltssozietät
Leopoldstrasse 4
80802 München (DE)**

(54) **Electronic module and fabrication method thereof**

(57)    The present invention provides an electronic module and fabrication method thereof in which the mounting area of an electronic component can be increased and connection failure between a ground electrode and metal shield can be suppressed to sufficiently ensure the connection strength between the ground electrode and conductive shield. In an electronic module 100, an electronic component 60 is mounted on a multi-layer substrate 1 incorporating a semiconductor device 30 and the like, and these are sealed by a sealing layer 110 of epoxy resin or the like, and further the sealing layer 110 and multi-layer substrate 1 are covered with a metal shield 120. The multi-layer substrate 1 and metal shield 120 are electrically connected via a ground electrode GN exposed as a result of cutting away a part of the multi-layer substrate 1.

## FIG.1

EP 2 009 692 A1

**Description**

CROSS-REFERENCES

This application relates to and claims priority from Japanese Patent Application No. 2007-172088, filed on June 29, 2007 and Japanese Patent Application No. 2008-153261, filed on June 11, 2008, the entire disclosure of which is incorporated herein by reference.

BACKGROUND OF THE INVENTION

Field of the Invention

The present invention relates to an electronic module and fabrication method thereof.

Description of the Related Art

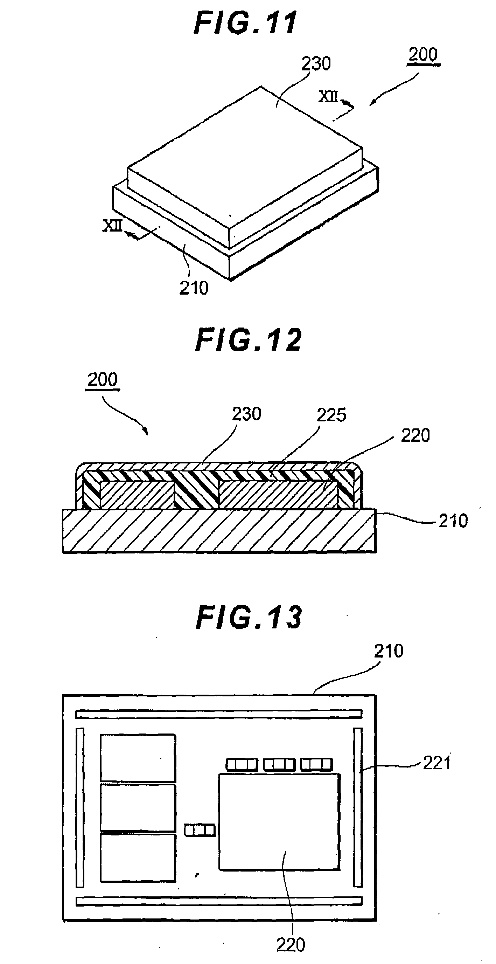

In recent years, with the downsizing and increasing performance of electronic apparatuses, there have also been demands for downsizing and higher performance of electronic modules mounted in the electronic apparatuses. FIG. 11 is a perspective view illustrating the main section of a prior art electronic module 200; and FIG. 12 is a cross-sectional view of the electronic module 200 taken along the line XII-XII.

As illustrated in FIGS. 11 and 12, the electronic module 200 includes: a circuit substrate 210 having an electronic component 220 mounted on at least one surface thereof; a sealing layer 225 composed of epoxy resin or the like covering the electronic component 220; and a metal shield 230 arranged to cover the sealing layer 225. The metal shield 230 plays a role of blocking electromagnetic wave from the outside to stabilize circuit characteristics and at' the same time, prevents electromagnetic wave radiated from the electronic component 220 from leaking to the outside, thereby allowing the electronic component 220 to operate normally.

FIG. 13 is a top view of the circuit substrate 210 before the sealing layer 225 and metal shield 230 are formed. As illustrated in FIG. 13, in the peripheral edge on the circuit substrate 210, there is formed a ground electrode 221. After this circuit substrate 210 is covered with the sealing layer 225 composed of epoxy resin or the like, the section of the sealing layer 225 over the ground electrode 221 is cut away using a cutoff blade or cutting blade (not illustrated) such as a dicing blade, so that the ground electrode 221 is exposed.

Thereafter, the metal shield 230 is formed by plating or the like on the sealing layer 225 and the exposed ground electrode 221, whereby the ground electrode 221 and metal shield 230 are electrically and mechanically connected (for example, refer to Japanese Patent Laid-Open No. 2004-193187).

However, in the prior art electronic module 200, since the ground electrode 221 lies on the surface of the circuit substrate 210, the peripheral edge area of the circuit substrate 210 is occupied by the ground electrode 221 and thus the mounting area of the electronic component 220 on the circuit substrate 210 is limited. Further, since the prior art electronic module 200 is designed from a viewpoint of ensuring the mounting area of the electronic component 220, it is difficult to set a sufficiently large exposed area of the ground electrode 221 to enhance the connection reliability and connection strength between the metal shield 230 and ground electrode 221, so the electrical and mechanical connection strength between the ground electrode 221 and metal shield 230 may be insufficient.

Furthermore, in cutting the sealing layer 225 by a cutoff blade, the actual cutting position by the cutoff blade may be dislocated from the target position due to misalignment and the like of the circuit substrate 210; as a result, the intended ground electrode 221 may not be exposed, resulting in connection failure between the ground electrode 221 and metal shield 230.

The present invention has been devised in view of the above circumstances and has an object to provide an electronic module and fabrication method thereof in which the mounting area of an electronic component can be increased, while the connection strength between a ground electrode and conductive shield can be sufficiently ensured and it is also possible to suppress connection failure between the ground electrode and metal shield even when a cutting position misalignment occurs.

SUMMARY OF THE INVENTION

To address the above problem, an electronic module according to the present invention includes: an insulating layer; a ground electrode arranged in the insulating layer and partly exposed from a side surface of the insulating layer; an electronic component mounted on the insulating layer; and a sealing layer which seals the electronic component; a conductive shield which covers the sealing layer and is electrically connected to the ground electrode at an exposed section of the ground electrode.

In the electronic module having the above configuration, the electronic component mounted on the insulating layer is sealed by the sealing layer; the resultant structure is wholly covered with the conductive shield; the conductive shield is electrically connected to the ground electrode partly exposed from the insulating layer; and the ground electrode is usually connected to a ground potential such as housing ground. As a result, the electronic component is electromagnetically shielded from the outside. In this way, instead of connecting the conductive shield to the ground electrode exposed from the substrate surface so as to cover the ground electrode, a part of the ground electrode is exposed from a side surface of the insulating layer and connected to the conductive shield at the exposed section; consequently, the peripheral edge area, needed in the prior art electronic module, for mounting the ground electrode on the substrate surface is reduced. In other words, the ground electrode and conductive shield are connected at an outer edge on the lower side of the electronic component mounting area, so a connection area between the two parts does not need to be specially provided.

In order to expose the ground electrode from a side surface of the insulating layer, the insulating layer may simply be drilled or cut in a depth direction. Thus, a part of the ground electrode is more correctly exposed, compared to the prior art in which the level in a depth direction is adjusted and the sealing layer is removed to expose the surface of the ground electrode. Consequently, non-exposure of the ground electrode caused by a cutting misalignment which may occur in the prior art electronic module is reliably eliminated, thus ensuring the connection with the conductive shield and also preventing the connection failure between the two parts.

Further, in an electronic module in which passive electronic components such as a resistor and capacitor are mounted in a substrate module or the like incorporating active components such as a semiconductor device (IC), a ground electrode is usually arranged in the insulating layer of the substrate module. In this case, the existing ground electrode arranged in the substrate module can also serve as the ground electrode of the electronic module. Consequently, there is no need to form an additional ground electrode used to shield the electronic module, so the number of processes and constituent components is reduced, significantly improving productivity.

Here, in the above configuration, a plurality of the ground electrodes having the exposed section are preferably provided in a direction perpendicular to the insulating layer. In this way, when a plurality of the ground electrodes exposed in a direction perpendicular to the insulating layer are provided, the exposed area of the ground electrode in the side surface of the insulating layer is enlarged, so the connection strength with the conductive shield can be further increased.

Also, the side surface of the exposed section of the ground electrode in the side surface of the insulating layer preferably has a prescribed inclination (taper) relative to a direction perpendicular to the insulating layer (a direction perpendicular to the insulating layer plane: normal line direction). With this configuration, since the ground electrode is cut off at an angle, the resultant exposed area is larger than that obtained when the ground electrode is cut off in a perpendicular direction. Thus, the connection area between the ground electrode and conductive shield is further enlarged.

Here, in the above configuration, the bottom end of the insulating layer is preferably positioned at an inner side relative to the end face of the conductive shield. With this configuration, the insulating layer can be prevented from protruding to the outside relative to the conductive shield, so that the substantial effective area of the substrate can be enlarged, allowing downsizing of the module.

According to the present invention, there is provided an electronic module fabrication method for fabricating a plurality of electronic modules including electronic components, the method including the steps of: forming an insulating layer having a ground electrode; mounting on the insulating layer, a plurality of electronic components included in the plurality of electronic modules; forming on the insulating layer and the plurality of electronic components, a sealing layer which seals the plurality of electronic components; cutting the insulating layer and the sealing layer so as to expose a part of the ground electrode from a side surface of the insulating layer; and forming a conductive shield which covers the sealing layer and is electrically connected to the ground electrode at an exposed section of the ground electrode. With this configuration, a plurality of the electronic modules according to the present invention can be effectively fabricated.

Here, the step of forming the insulating layer having the ground electrode includes forming the insulating layer in which the ground electrode extends across at least two areas of the areas where the electronic modules are formed; and the step of cutting the insulating layer and sealing layer includes cutting the insulating layer and sealing layer so as to define each of the areas where the electronic modules are formed and to.expose a part of the ground electrode from the side surface of the insulating layer.

With this configuration, a plurality of the electronic modules according to the present invention can be effectively fabricated. Furthermore, the ground electrode extends across at least two areas of the areas where the electronic modules.are formed, a plurality of the electronic components included in the plurality of electronic modules are mounted and the resultant structure is wholly sealed by the sealing layer, and thereafter the insulating layer is cut so as to define each of the electronic modules, the ground electrode is divided and exposed, and the conductive shield is formed across a plurality of the electronic modules to complete the shield all at once and then separation is carried out, so productivity can be improved. Further, since there is no need to provide a connection area between the ground electrode and conductive shield on the peripheral edge of the electronic module substrate in addition to the electronic component mounting area, the distance between the electronic modules can be shortened and thus the arrangement density of electronic modules in a common substrate is enhanced, further improving productivity.

Here, in forming the ground electrode, a plurality of the ground electrodes are preferably formed in a direction perpendicular to the insulating layer; and in cutting the insulating layer and sealing layer, the cutting is preferably carried out so that a plurality of the ground electrodes are preferably exposed from the side surface of the insulating layer. For example, when a plurality of insulating layers and a plurality of ground electrodes are alternately stacked and.then the insulating layers are cut in a depth direction, a plurality of the ground electrodes can be exposed easily and correctly from the side surface of the insulating layer.

In cutting the insulating layer and sealing layer, the cutting is preferably carried out so that the exposed section of the ground electrode on the side surface of the insulating layer has a prescribed inclination (taper) relative to a direction perpendicular to the insulating layer. More specifically, for example, there may be performed dicing in which the tip end of a cutting blade having a spire-shaped (tapered) tip end side wall reaches the buried section of the ground electrode in the insulating layer.

Also, in separating multiple electronic modules, the cutoff is preferably performed by making an incision from a surface opposite to the cut surface to the cut position; and in performing the cutoff by making an incision, the incision is preferably made so that the bottom end of the insulating layer is positioned at an inner side relative to the end face of the conductive shield. With this method, in separating the electronic modules, the cutoff portion can be prevented from protruding to the outside relative to the conductive shield, so that the substantial effective area of the substrate can be enlarged, allowing downsizing of the module. Here, in performing the cutoff by making an incision, the incision is preferably made using a cutoff blade having a blade thickness larger than that of the cutoff blade used for the cutting.

According to the electronic module and fabrication method thereof of the present invention, the conductive shield used to shield the electronic components is connected with the ground electrode exposed on the side surface of the insulating layer; thus the ground electrode arranged in the peripheral edge of substrate and its formation area according to the prior art can be reduced to enlarge the mounting area of the electronic components, allowing further downsizing by higher mounting density; further the ground electrode and conductive shield can be reliably connected and in addition, connection failure caused by non-exposure of the ground electrode can be prevented, allowing improvement in product reliability, yield rate and productivity.

BRIEF DESCRIPTION OF THE DRAWINGS

FIG. 1 is a schematic cross-sectional view illustrating the main section of an electronic module according to the present embodiment;

FIG. 2 is a perspective view schematically illustrating the structure of a semiconductor device;

FIG. 3 is a process diagram illustrating an exemplary procedure of fabricating the electronic module;

FIG. 4 is a process diagram illustrating an exemplary procedure of fabricating the electronic module;

FIG. 5 is a process diagram illustrating an exemplary procedure of fabricating the electronic module;

FIG. 6 is a process diagram illustrating an exemplary procedure of fabricating the electronic module;

FIG. 7 is a plan view illustrating an exemplary relationship between a ground electrode and cutting reference line;

FIG. 8 is a partial enlarged view of a cut surface of a multi-layer substrate;

FIG. 9 is a schematic cross-sectional view illustrating the main section of the electronic module;

FIG. 10 is a process diagram illustrating another exemplary procedure of fabricating the electronic module;

FIG. 11 is a perspective view illustrating the main section of a prior art electronic module;

FIG. 12 is a cross-sectional view of the electronic module illustrated in FIG. 11 taken along the line XII-XII;

FIG. 13 is a top view illustrating the main section of a circuit substrate;

FIG. 14 is a schematic cross-sectional diagram of an electronic module formed by a separation process;

FIG. 15 is a schematic cross-sectional diagram of an electronic module formed by a separation process;

FIG. 16 is a process diagram illustrating an exemplary procedure of fabricating the electronic module;

FIG. 17 is a process diagram illustrating an exemplary procedure of fabricating the electronic module;

FIG. 18 is a process diagram illustrating an exemplary procedure of fabricating the electronic module;

FIG. 19 is a process diagram illustrating an exemplary procedure of fabricating the electronic module;

FIG. 20 is a process diagram illustrating an exemplary procedure of fabricating the electronic module;

FIG. 21 is a process diagram illustrating an exemplary procedure of fabricating the electronic module;

FIG. 22 is a process diagram illustrating an exemplary procedure of fabricating the electronic module; and

FIG. 23 is a process diagram illustrating an exemplary procedure of fabricating the electronic module.

# EP 2 009 692 A1

DETAILED DESCRIPTION OF THE PREFERRED EMBODIMENTS

An embodiment of the present invention will be described below with reference to the drawings. Like reference characters denote the same or similar parts throughout the figures, and repeated explanation thereof is omitted. Except if otherwise mentioned, the positional relationship (left, right, top, bottom and the like) is based on that illustrated in the drawings. Further, the size ratio in the drawings is not limited to that illustrated in the drawing; the embodiment described below are merely exemplary of the present invention, and are not be construed to limit the scope of the present invention; and many modifications to the embodiment are possible without departing from the gist of the invention.

Embodiment 1

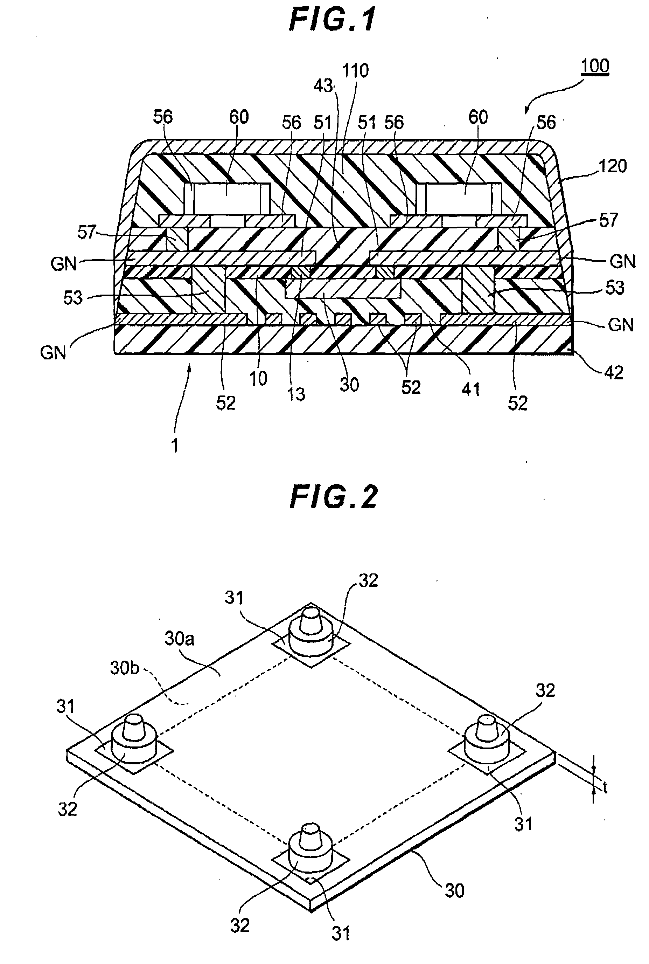

FIG. 1 is a schematic cross-sectional view illustrating the main section of an electronic module according to the present embodiment. An electronic module 100 includes; a multi-layer substrate 1 having mounted thereon an electronic component 60 and also incorporating a semiconductor device 30 and the like; a sealing layer 110 which seals the electronic component 60 mounted on the multi-layer substrate 1, using epoxy resin or the like; and a metal shield 120 which covers the sealing layer 110 and multi-layer substrate 1. The multi-layer substrate 1 and metal shield 120 are electrically connected via a ground electrode GN exposed by cutting away a part of the multi-layer substrate 1.

In the multi-layer substrate 1, a resin layer 41 is formed on one surface (the illustrated lower surface) of a base 10; and the semiconductor device 30 is buried in the interior of the resin layer 41. On the other surface (the illustrated upper surface) of the base 10, there is formed a wire 51 including the ground electrode GN; and the semiconductor device 30 arranged on the one surface of the base 10 and the wire 51 arranged on the other surface of the base 10 are electrically connected via a connection section 13.

On the illustrated lower surface (the side opposite from the base 10) of the resin layer 41, there is formed a wire 52 including the ground electrode GN; and the wire 51 on the base 10 and the wire 52 on the resin layer 41 are electrically connected via a via 53. Also, on the surface in the wire 52 side of the resin layer 41, there is formed a resin layer 42.

Further, on the surface in the wire 51 side of the base 10, there is formed a resin layer 43; and a wire 56 is formed on the surface of the resin layer 43. The wire 56 and wire 51 are connected via a via 57 (specifically a conductor filled in a via hole) which penetrates through the resin layer 43; and the electronic components 60 such as a resistor and capacitor are arranged in the wire 56. In this way, the "resin layer" according to the present invention is constituted of the resin layers 41, 42 and 43.

Specific examples of materials used for the resin layers (insulating layers) 41, 42 and 43 include simple resins such as vinyl benzyl resin, polyvinyl benzyl ether compound resin, bismaleimide triazine resin (BT resin), polyphenylene ether (polyphenylene ether oxide) resin (PPE, PPO), cyanate ester resin, epoxy + active ester curable resin, polyphenylene ether resin (polyphenylene oxide resin), curable polyolefin resin, benzocyclobutene resin, polyimide resin, aromatic polyester resin, aromatic liquid crystal polyester resin, polyphenylene sulfide resin, polyetherimide resin, polyacrylate resin, polyether ether ketone resin, fluorine resin, epoxy resin, phenol resin and benzoxazine resin; materials obtained by adding, to these resins, silica, talc, calcium carbonate, magnesium carbonate, aluminum hydroxide, magnesium hydroxide, aluminum borate whisker, potassium titanate fibers, alumina, glass flakes, glass fibers, tantalum nitride, aluminum nitride, or the like; materials obtained by adding, to the aforementioned resins, metal oxide powder containing at least one metal selected from magnesium, silicon, titanium, zinc, calcium, strontium, zirconium, tin, neodymium, samarium, aluminum, bismuth, lead, lanthanum, lithium and tantalum; materials obtained by incorporating, into the aforementioned resins, glass fibers or resin fibers such as aramid fibers; and materials obtained by impregnating the aforementioned resins in a glass cloth, aramid fibers, nonwoven fabric, or the like. A suitable material can be selected and used as appropriate from the perspectives of electric properties, mechanical properties, water absorption, reflow resistance and the like.

FIG. 2 is a perspective view schematically illustrating the structure of the semiconductor device 30. The semiconductor device 30 is a bare chip semiconductor IC (die) or the like, and has many land electrodes 31 arranged on a primary surface 30a having a substantially rectangular board shape. In FIG. 2, the land electrode 31 and a bump 32 to be described later are illustrated only in the four corners; illustration of the land electrode 31 is omitted except the above ones. The type of the semiconductor device 30 is not particularly limited, but examples thereof include a digital IC having a significantly high operating frequency such as CPU and DSP.

Though not particularly limited, the rear surface 30b of the semiconductor device 30 is polished so that thickness t (the distance from the primary surface 30a to the rear surface 30b) of the semiconductor device 30 is smaller than that of the typical semiconductor IC, and preferably equal to or smaller than 200 $\mu$m, and more preferably 20 to 50 $\mu$m. In order to slim down the semiconductor device 30, roughening processing by etching, plasma processing, laser processing, blasting, buffing, chemical treatment or the like is preferably applied to the rear surface 30b.

The polishing of the rear surface 30b of the semiconductor device 30 can be performed after separation into the individual semiconductor devices 30 has been performed by dicing. Alternatively, many electronic components may be polished collectively in the wafer state and may be subsequently separated into the individual semiconductor devices 30 by dicing. Or an alternative method is such that many electronic components is polished all at once in the wafer state and then separation into the individual semiconductor devices 30 is performed by dicing and thereafter the individual electronic components are polished to further slim down the semiconductor devices 30.

A bump (terminal) 32 that is a type of a conductive protrusion is formed on each land electrode 31. The type of the bump 32 is not particularly limited, and examples of the bump 32 include stud bump, plate bump, plating bump and ball bump. In FIG. 2, a stud bump is illustrated. When a stud bump is used as the bump 32, the bump can be formed by wire bonding using silver (Ag) or copper (Cu); when a plate bump is used, the bump can be formed by plating, sputtering or deposition. When plating bumps are used, the bumps may be formed by plating, and when ball bumps are used, the bumps may be formed by either mounting a solder ball on the land electrode 31 and then melting the same or by printing a cream solder on the land electrode and then melting the same. Also usable are bumps having a conical shape, a cylindrical shape or the like formed by screen-printing and curing a conductive paste, or bumps formed by printing a metal paste and sintering the same by heating.

The type of metal used for the bump 32 is not particularly limited, and examples thereof include gold (Au), silver (Ag), copper (Cu), nickel (Ni), tin (Sn), chrome (Cr), nickel-chrome alloy and solder. Among these, copper is preferably used. When copper is used for the bump 32, a high-strength bond to the land electrode 31 can be achieved, compared to a case where gold is used, and thus the reliability of the semiconductor device 30 itself can be enhanced.

The dimensions and shape of the bump 32 can be properly set according to the interval (pitch) between the land electrodes 31. For example, when the pitch of the land electrode 31 is about 100 $\mu$m, the maximum diameter of the bump 32 is 10 to 90 $\mu$m and the height , thereof, 2 to 100 $\mu$m. The bump 32 can be joined to each of the land electrodes 31 by use of a wire bonder after the wafer has been cut off and separated into individual semiconductor devices 30 by dicing.

In the semiconductor device 30 having the above configuration, each of the bumps 32 is arranged in the interior of the resin layer 41 while connected to the wire 51 at the connection section 13 (FIG. 1).

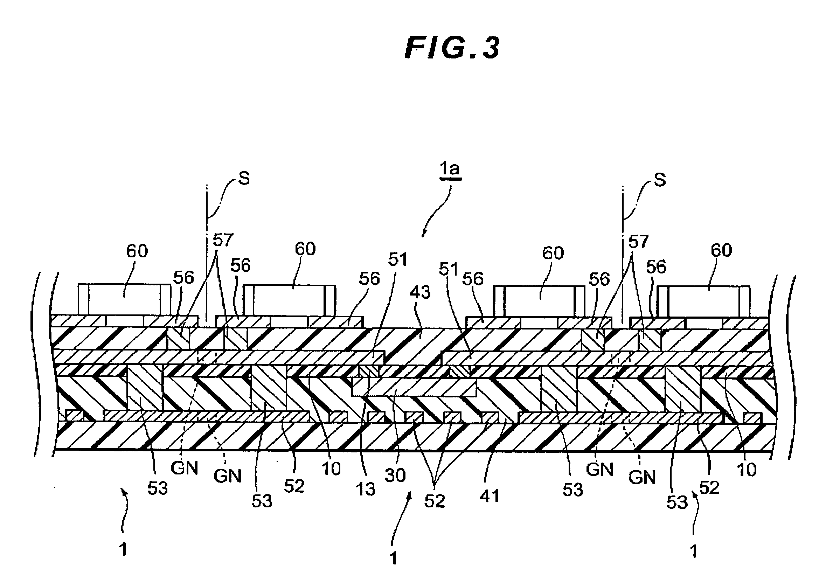

The method of fabricating a plurality of the electronic modules 100 according to the present embodiment all at once will be described with reference to FIGS. 3 to 8. In the figures, cutting reference line S used for division into the electronic modules 100 is indicated by the dashed-dotted line.

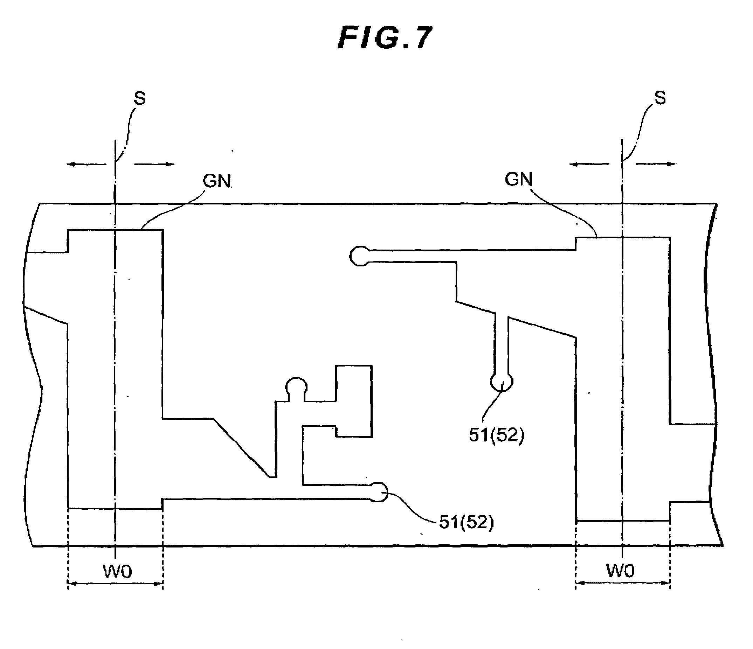

Firstly there is formed an integrated multi-layer substrate 1a obtained by joining a plurality of the multi-layer substrates 1 illustrated in FIG. 1 to form a single substrate (refer to FIG. 3). FIG. 7 is a plan view illustrating an exemplary relationship between the ground electrode GN and cutting reference line S formed in the wire 51, wire 52 and the like. As illustrated in FIG. 7, electrode width W0 of the ground electrode GN formed in the wire 51, wire 52 and the like is set larger than the wire width, and according to the present embodiment, the ground electrode GN is formed so as to extend across the wires 51 and 52 of the adjoining multi-layer substrates 1. In other words, there is formed the integrated multi-layer substrate 1a including the ground electrode GN extending across the adjoining multi-layer substrates 1. When the ground electrode GN is formed in this way, even when the actual cutting position is dislocated from the cutting reference line S, if the misalignment falls into the electrode width W0 of the ground electrode GN, the ground electrode GN can be correctly exposed. Accordingly, in contrast to the prior art in which the level in a depth direction is adjusted and the sealing layer is removed to expose the.surface of the ground electrode, a part of the ground electrode is correctly exposed. Thus, non-exposure of the ground electrode caused by a cutting misalignment which may occur in the prior art electronic module is reliably eliminated, thus ensuring the connection with the conductive shield and preventing the connection failure between the two parts.

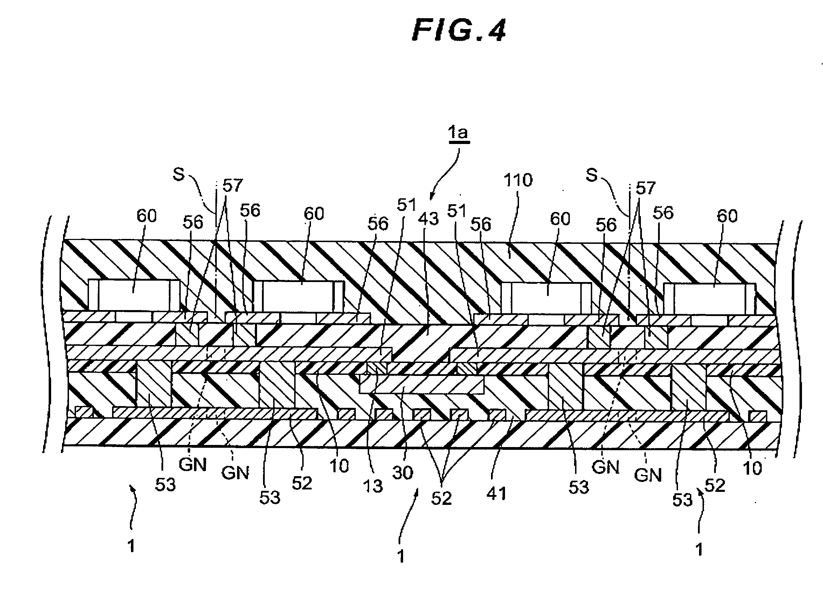

Subsequently, as illustrated in FIG. 4, the sealing layer 110 composed of epoxy resin is formed so as to cover the electronic component 60 mounted on the surface of the integrated multi-layer substrate 1a. The sealing layer 110 contains epoxy resin of 1 to 500 Pa.s, filler having an average particle diameter less than 100 $\mu$m, and curing agent, for example. An inorganic material such as silica and aluminum hydroxide is used for the filler. A curing agent such as anhydride and amine family is selected according to the mechanical characteristics of the electronic component 60 and used for the sealing layer 110.

The sealing layer 110 composed of epoxy resin is supplied around the electronic component 60 by use of a fixing frame and squeegee (not illustrated) and thereafter defoaming is performed using a vacuum chamber. More specifically, the vacuum of the vacuum chamber is set equal to or lower than $1.0 \times 10^2$ Pa to allow defoaming. Here, in order to further remove bubbles contained in the epoxy resin, before supplying epoxy resin, the vacuum of the vacuum chamber is adjusted equal to or lower than $1.0 \times 10^2$ Pa, and then epoxy resin is supplied.

Thereafter, the vacuum of the vacuum chamber is set equal to or more than $1.0 \times 10^4$ Pa. When the vacuum is lowered in this way, bubbles in the paste can be removed by the pressure difference from the initial state.

After the supplying of epoxy resin and defoaming, the sealing layer is placed in an oven at a degree of 100°C for an hour, and further placed in an oven at a degree of 150°C for three hours to cure the sealing layer 110 composed of epoxy resin. In this way, the curing of the sealing layer 110 is gradually performed in two stages, so that the difference of thermal expansion coefficient between the sealing layer 110 and integrated multi-layer substrate 1a and the internal stress caused by curing and contraction of the sealing layer 110 are decreased. As a result, warpage of the integrated multi-layer substrate 1a can be reduced to improve the reliability of thermal cycle and the like.

Further, after being placed in an oven at a degree of 150°C for three hours to be cured, the sealing layer 110 is cooled at a degree equal to or lower than 0.5°C/minute. In this way, when the temperature is gradually'lowered, warpage of the integrated multi-layer substrate 1a can be further reduced.

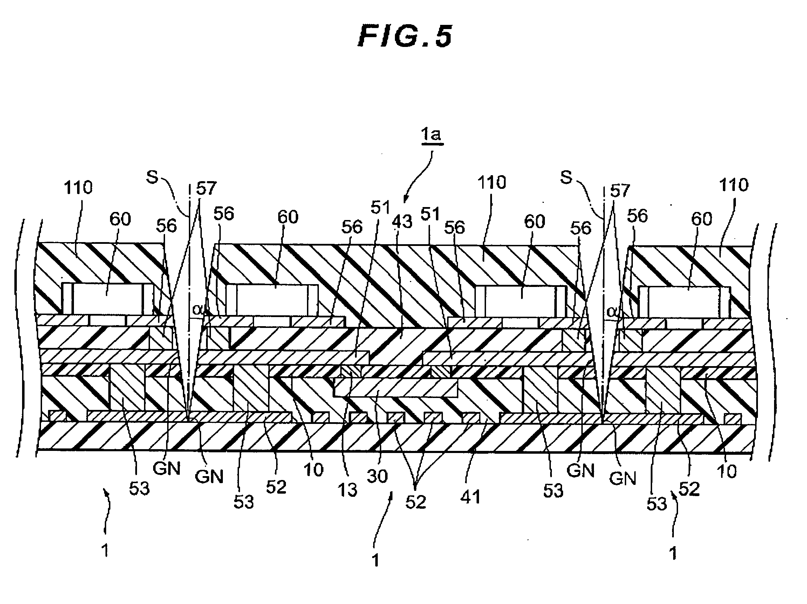

Subsequently, as illustrated in FIG. 5, at least a part of the ground electrode GN is exposed by cutting the sealing layer 110 and integrated multi-layer substrate 1a by use of a dicing blade or the like along the cutting reference line S so that a V-shaped cross section (refer to inclination angle $\alpha$ illustrated in FIG. 5) is formed. In this way, when cutting is performed at a prescribed inclination angle $\alpha$ relative to the cutting reference line (a direction orthogonal to the multi-layer substrate) S, the exposure area of the ground electrode GN is increased. As described above, the exposed section of the ground electrode GN is connected to the metal shield. Accordingly, when the exposed section of the ground electrode GN is increased, the connection strength with the metal shield can be increased. Here, in this process, the multi-layer substrates 1 are not completely separated, but the depth of a groove formed by cutting is set so that the ground electrode GN can be exposed (refer to FIG. 5).

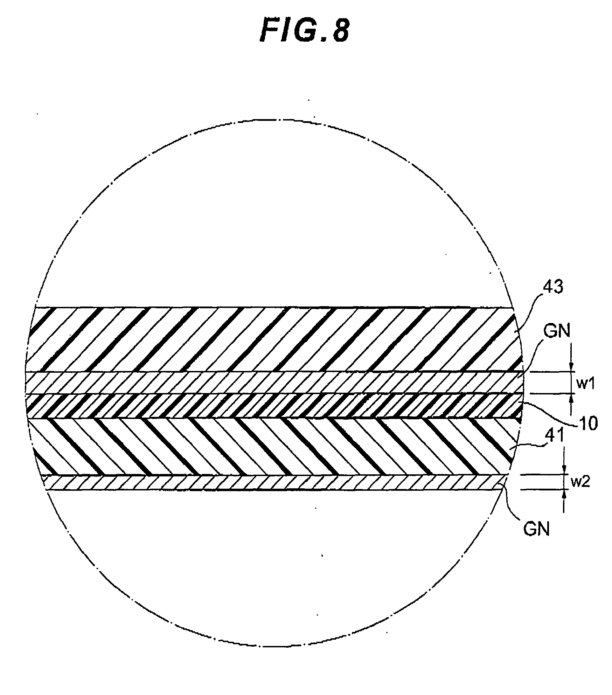

FIG. 8 is a partial enlarged view of a cut surface (a side surface of the multi-layer substrate) of the multi-layer substrate 1. As illustrated in FIG. 8, according to the present embodiment, the ground electrode GN having a line width w1 is exposed on the upper surface of the base 10; and the ground electrode GN having a line width w2 is exposed on the lower surface of the resin layer 41. In this way, there are a plurality of the ground electrodes GN exposed in a direction perpendicular to the insulating layer including the resin layer 41 (in other words, the ground electrode GN has plural exposed sections in a direction perpendicular to the insulating layer), so the exposed area of the ground electrode GN in the side surface of the insulating layer is enlarged and thus the connection strength with the metal shield can be further increased. In this case, when cutting is performed using a dicing blade or the like, inclination angle $\alpha$ is set so that the ground electrode GN is exposed by a desired line width (so that a desired exposed area of the ground electrode GN is provided).

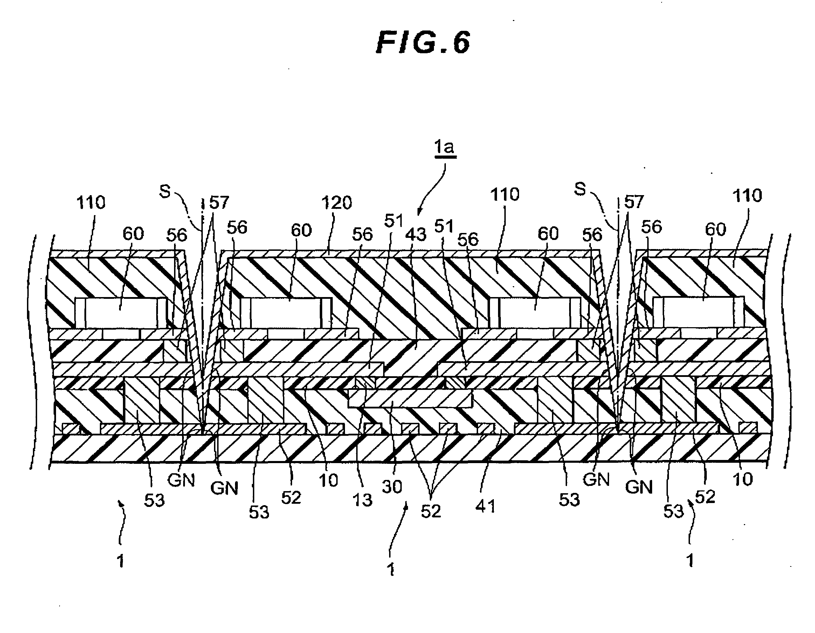

Subsequently, as illustrated in FIG. 6, the metal shield (conductive shield) 120 is formed by plating in the multi-layer substrate 1 where the sealing layer 110 and ground electrode GN are exposed. As a result, the metal shield 120 and ground electrode GN are electrically connected and at the same time, shielding effect is provided.

To be more in detail, firstly a core is formed using Pd on the surface of the sealing layer 110 and plated copper of 0.5 $\mu$m is formed by electroless plating. Further, copper plating is performed by electrolytic plating to form.the metal shield 120 with dense copper coating of 10 $\mu$m on the sealing layer 110. Here, as the metal material used to form the metal shield 120, instead of copper (Cu), there can be used a material having a high electric conductivity such as silver (Ag). When the conductor resistance of the metal shield 120 is lowered using such metal material, satisfactory shielding effect can be provided.

Here, electroless plating is characterized in that coating can be formed on an insulating material and a uniform film can be formed in a section wetted with plating liquid. However, electroless plating is disadvantageous in when the film forming speed is low, it is difficult to form a film of a thickness equal to or less than 3 $\mu$m and when the film thickness is large, internal stress increases and the interface between the mold resin layer and coating layer is easily peeled. Thus, according to the present embodiment, there is simultaneously used electrolytic plating in which coating growth speed is high and a thick film can be formed, so high quality can be ensured at low cost.

The film thickness of the formed metal shield 120 is preferably equal to or more than substantially 1 micron. In forming the metal shield 120, the metal shield 120 of copper is formed by electroless plating on the sealing layer 110 and thereafter the metal shield 120 of copper is further formed by electrolytic plating on the resultant surface to make the metal shield 120 more dense, so the connection resistance of the ground electrode GN is lowered to stabilize the ground potential of the metal shield 120 formed on the sealing layer 110, thus enhancing the shielding effect.

After the metal shield 120 is formed in this way, the multi-layer substrate 1 is separated along the cutting reference line S, whereby a plurality of the electronic module 100 illustrated in FIG. 1 are formed. In this case, when the multi-layer substrate 1 (i.e., electronic module 100) is separated, a groove has already been formed by cutting, so the separation can be made without using a cutting blade such as a dicing blade. Needless to say, the multi-layer substrate 1 may be separated using a cutting blade such as a dicing blade.

As described above, according to the electronic module 100 and its fabrication method of the present embodiment, instead of connecting a conductive shield to a ground electrode exposed on the substrate surface so as to cover the ground electrode as with the prior art, a part of the ground electrode GN is exposed from the side surface of the insulating layers including the resin layers 41, 42 and 43 and then connected at the exposed section with the metal shield 120 acting as a conductive shield, whereby the peripheral edge area, needed in the prior art electronic module, for mounting the ground electrode on the substrate surface is reduced. In other words, since the ground electrode and conductive shield are connected at an outer edge on the lower side of the electronic component mounting area, a connection area between the two parts does not need to be specially provided.

Further, according to the present embodiment, the insulating layer including the resin layers 41, 42 and 43 are cut in a depth direction to expose the ground electrode GN from the side surface of the insulating layer. Accordingly, a part of the ground electrode is correctly exposed, compared to the prior art in which the level in a depth direction is adjusted and the sealing layer is removed to expose the surface of the ground electrode. Consequently, non-exposure of the ground electrode caused by a cutting misalignment which may occur in the prior art electronic module is reliably eliminated, thus ensuring the connection with the conductive shield and preventing the connection failure between the two parts.

Further, according to the present embodiment, the substrate is cut so that the side surface of the exposed section of the ground electrode GN in the side surface of the insulating layer including the resin layers 41, 42 and 43 preferably has a prescribed inclination (taper) relative to the direction perpendicular to the insulating layer (a direction perpendicular to the insulating layer plane: normal line direction). Accordingly, the ground electrode GN is cut off at an angle and thus the resultant exposed area is made larger than that obtained when the ground electrode GN is cut off in a perpendicular direction. Thus, the connection area between the ground electrode GN and conductive shield is further enlarged.

Further, according to the present embodiment, in exposing the ground electrode GN from the side surface of the insulating layer, cutting is performed so that the buried section of the ground electrode GN in the insulating layer including the resin layers 41, 42 and 43 is reached, and thereafter folding is performed along the groove formed by the cutting to separate each of the electronic modules. In contrast, according to the prior art, when each of the electronic modules are separated after the substrate has been cut to expose the ground electrode on the substrate surface, the substrate needs to be again aligned to a reference position set for the separation so as to cut off the substrate. Thus, according to the present embodiment, the process of separating the electronic module is simplified, considerably improving productivity.

As described above, the present invention is not limited to the above embodiment, and appropriate modifications to the embodiment are possible without departing from the gist of the invention. For example, in the above embodiment, there was described a case where the exposed area of the ground electrode GN is varied by inclination angle $\alpha$ at which the multi-layer substrate 1 is cut. Instead, the exposed area of the ground electrode GN may be varied by the number of the exposed ground electrodes GN or the film thickness (refer to FIG. 8) of the ground electrode GN. In this case, if a desired exposed area of the ground electrode GN is provided by varying the number of the exposed ground electrodes GN or the film thickness of the ground electrode GN, cutting may be performed without setting the inclination angle (i.e., inclination angle $\alpha$ = 0°). Needless to say, the exposed area of the ground electrode GN may be varied by combining the above methods. Here, as the ground electrode GN to be exposed, all the ground electrodes included in the multi-layer substrate 1 can be used, including the ground electrode of the electronic component 60 mounted on the multi-layer substrate 1 and the ground electrode of the semiconductor device 30.

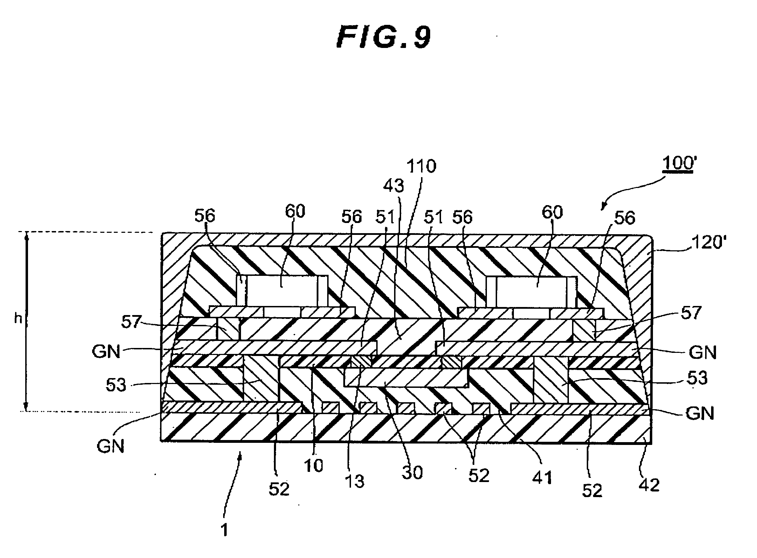

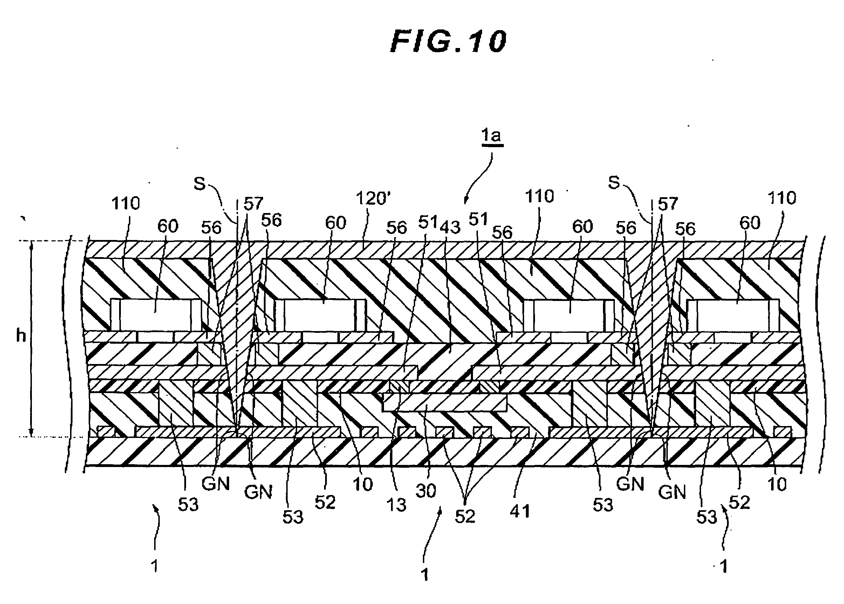

Instead of the metal shield 120 having a substantially uniform film thickness, there may be formed a metal shield 120' having different film thicknesses illustrated in FIG. 9. FIG. 10 is a process diagram illustrating an exemplary fabrication procedure of an electronic module according to a variation 2, and corresponds to FIG. 6. The same reference characters are applied to parts corresponding to those of FIG. 6, and detailed explanation thereof is omitted.

As illustrated in FIG. 10, in a multi-layer substrate 1 having a sealing layer 110 and ground electrode GN exposed, there is formed the metal shield 120' having a substantially constant height h by using vapor deposition, sputtering or the like. After forming such metal shield 120', the substrate is cut off by use of a cutting blade such as a dicing blade along a cutting reference line S. As a result, it is possible to form an electronic module 100' which, as illustrated in FIG. 9, has a different film thickness depending on the section thereof and has high tolerance against impact from the side surface.

Further, instead of the metal shield 120 formed of a metal film using a metal material such as copper, the metal shield 120 may be formed by a substantially box-shaped metal cap using a metal material such as 42 alloy, kovar, phosphor bronze or iron.

Further, for the metal shield 120, resistance against environment of the module components may be enhanced by forming an antioxidant layer on the surface of the metal film. As the antioxidant layer, a reflow-resistant resin is used as a coating material; and in order to enhance the degree of adhesion to the wired substrate with solder, for example, a metal layer of Sn, Ni or the like may be formed by plating, sputtering or the like. Further, not a plurality of ground electrodes GN but a single ground electrode GN may be provided; and instead of the ground electrode GN, another wiring layer may be formed in the multi-layer substrate 1.

Embodiment 2

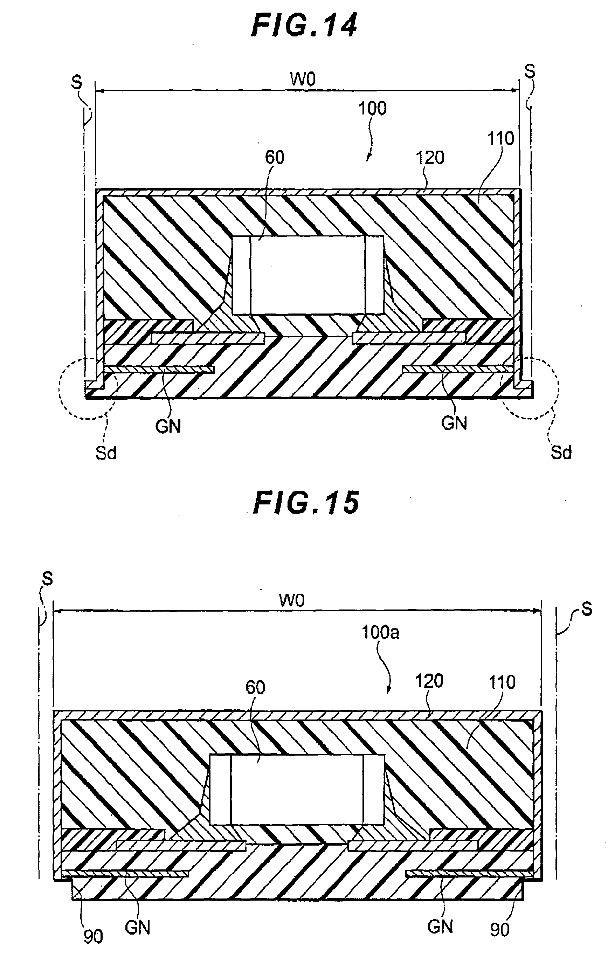

FIG. 14 is a view illustrating a schematic configuration of an electronic module 100 formed by the multi-layer substrate separation process according to the first embodiment and its variation; and FIG. 15 is a view illustrating a schematic configuration of an electronic module 100a formed by the multi-layer substrate separation process according to a second embodiment. In the following description, the substrate surface in a side on which an electronic component is mounted is referred to as "front surface"; and the substrate surface in an opposite side is referred to as "rear surface".

According to the first embodiment, the cutting (what is called a half cutting) is performed by use of a dicing blade or the like along the cutting reference line S while avoiding complete separation from the multi-layer substrate so that a part of the ground electrode GN is exposed; and after the sealing layer 110, metal shield 120 and the like have been formed, the cutoff (what is called a full cutting) or breaking is performed from the upper part of the substrate along the cutting reference line S, whereby the separation is performed. As a result, multiple separated electronic modules 100 are formed; but as illustrated in FIG. 14, the bottom part of each separated electronic module 100 protrudes to the outside by a cutoff portion Sd. Consequently, for example, as illustrated in FIG. 14, even when the width of the electronic module 100 is set to W0, the width of the electronic module 100 increases by the cutoff portion Sd, resulting in size growth. Thus, in designing the electronic module 100, the cutoff portion Sd must be considered, and thus the substantial effective area of the substrate decreases, making it difficult to downsize the module.

According to the second embodiment, half cutting is performed from the front surface of the substrate along the cutting reference line S so that a part of the ground electrode GN is exposed, and thereafter an incision is made from the rear surface to the half cutting position by use of a cutoff blade having a blade thickness larger than that of the cutoff blade used for the half cutting, whereby full cutting is performed (refer to FIG. 15). When the separation into electronic modules is performed in this way, the bottom end 90 of each electronic module is positioned at an inner side relative to the end of the metal shield 120. Accordingly, the size of the electronic module 100 can be set without considering the cutoff portion Sd protruding to the outside relative to the metal shield 120 as illustrated in FIG. 14, so the substantial effective area of the substrate can be increased, allowing downsizing of the module.

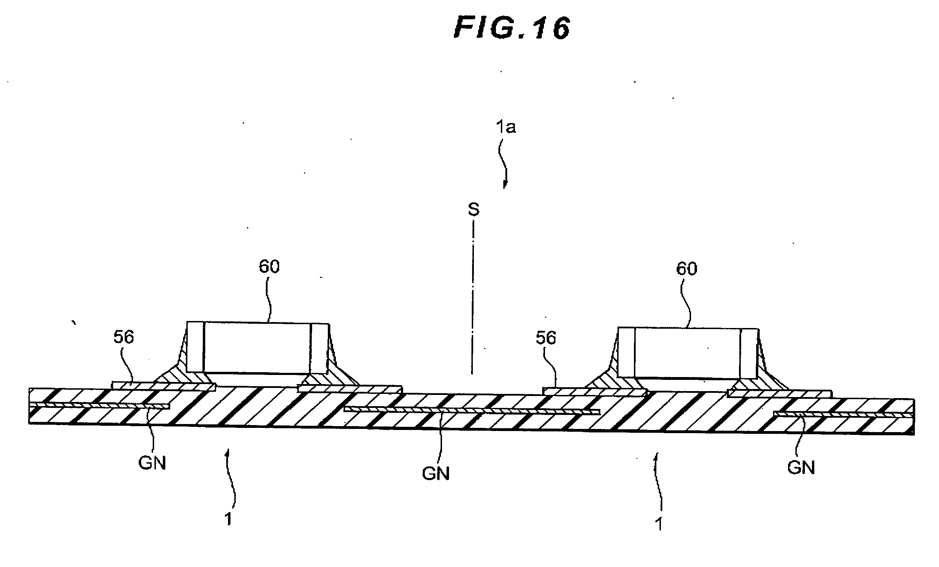

The method of fabricating multiple electronic modules 100a according to the present embodiment all at once will be described with reference to FIGs. 16 to 21. In the figures, cutting reference line S used for separating the electronic modules 100a is indicated by the dashed-dotted line.

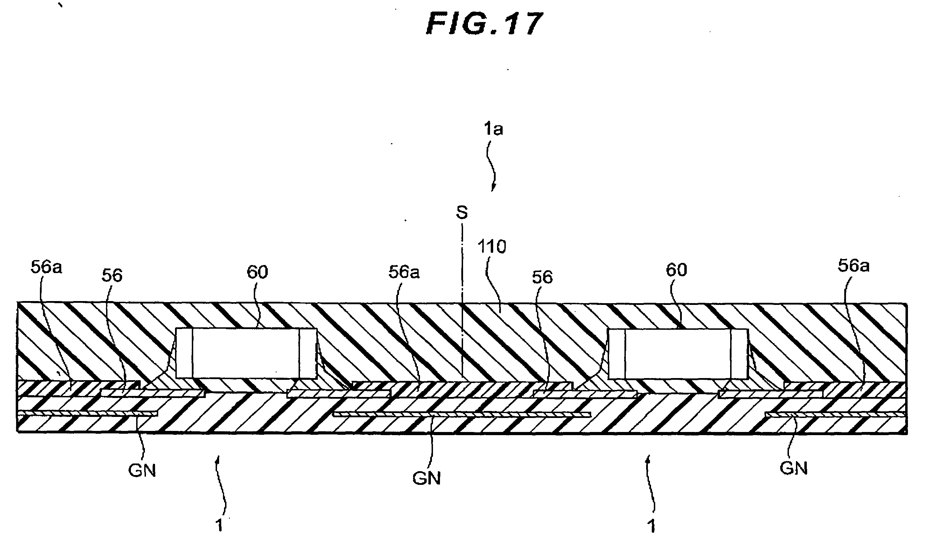

As illustrated in FIG. 16, after an integrated multi-layer substrate 1a having mounted thereon an electronic component 60 is formed, a resist 56a is, as illustrated in FIG. 17, formed so as to cover a wire 56 of the electronic component 60 mounted on the front surface of the integrated multi-layer substrate 1a, and thereafter a sealing layer 110 composed of epoxy resin is formed so as to cover the whole electronic component 60.

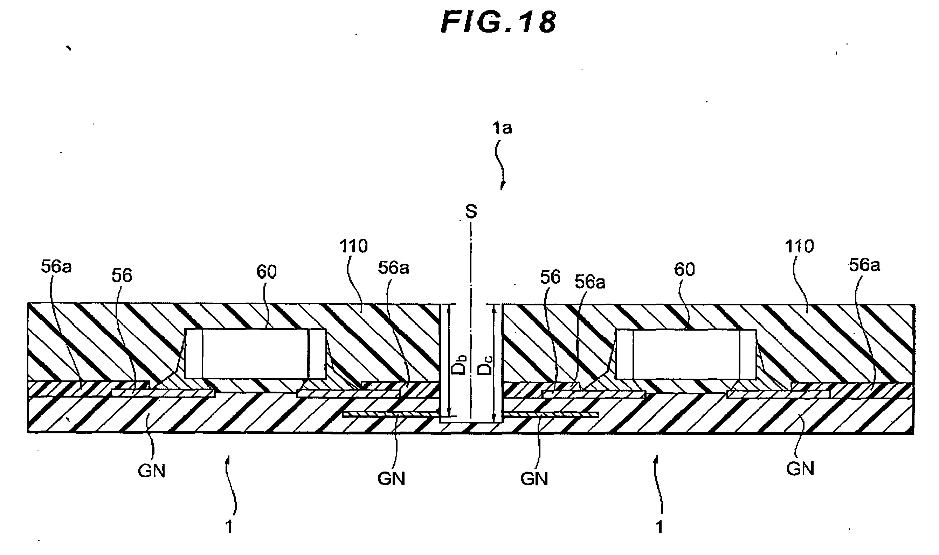

Subsequently, the integrated multi-layer substrate 1a is half-cut along the reference line S by use of a dicing blade, so that a concave 70 of a depth Dc is formed (refer to FIG. 18). The depth Dc of the concave 70 may be set to any value as long as the value is, as indicated by formula (1), larger than a depth Db by which a part of the ground electrode GN contained in the integrated multi-layer substrate 1a is exposed.

$$Dc > Db \quad ... \quad (1)$$

In this way, when the cutting by a dicing blade is controlled so that an exposed section is produced in the contained ground electrode GN, the ground electrode GN and the metal shield 120 to be described later can be connected at the side surface.

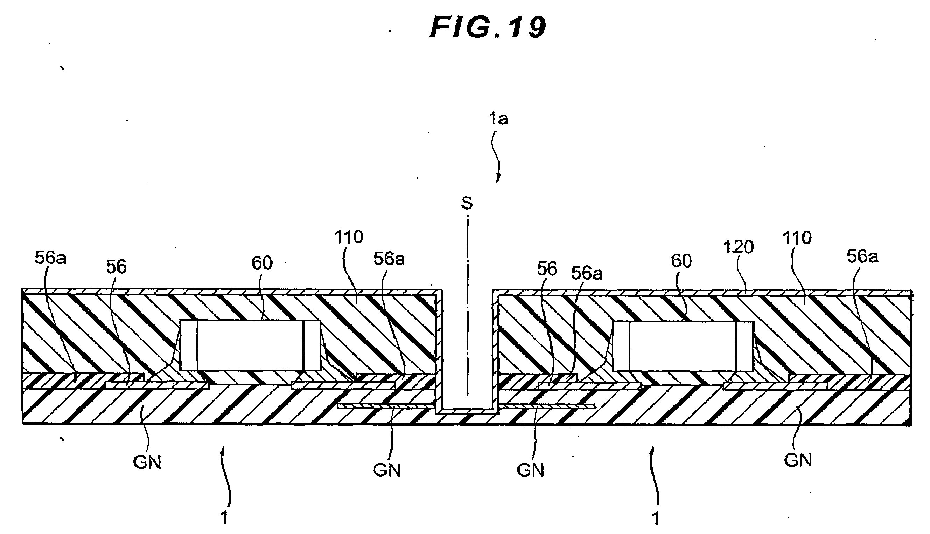

Then, electroless plating is performed on the integrated multi-layer substrate 1a having formed therein the concave 70; for example, copper plating of 0.5 $\mu$m is formed by electroless plating. Further, copper plating is performed by electrolytic plating to form the metal shield 120 with dense copper coating of 20 $\mu$m on the sealing layer 110 (refer to FIG. 19).

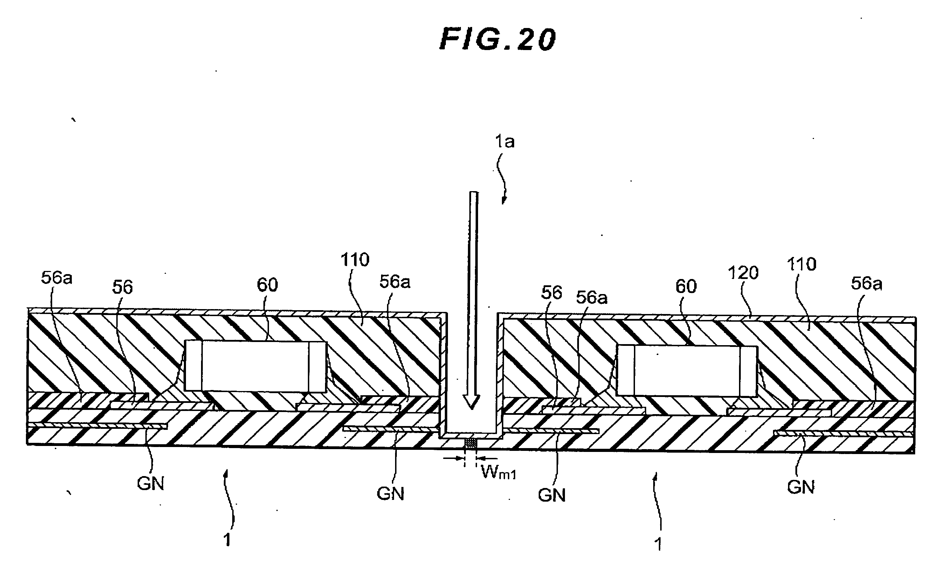

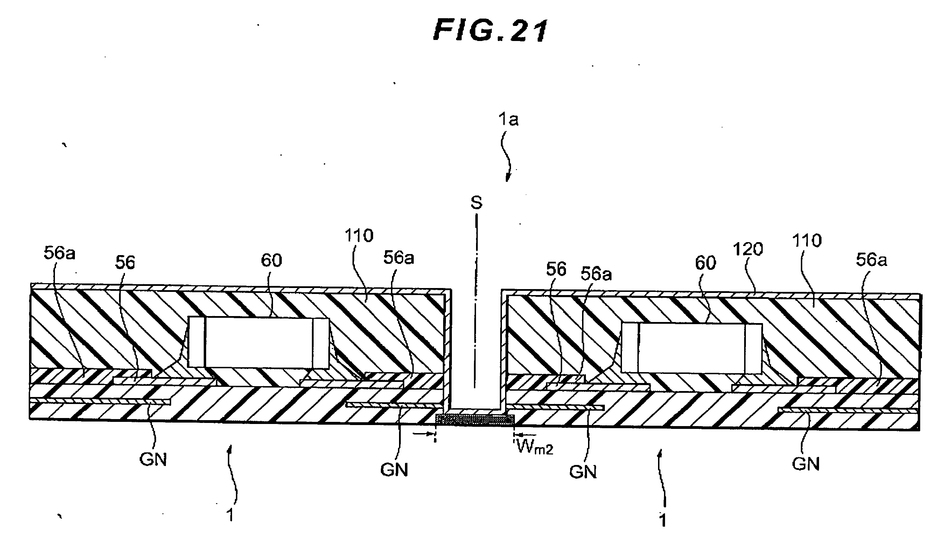

Thereafter, full cutting is performed using a dicing blade for division into electronic modules 1. Here, FIG. 20 is a view illustrating an example of separation process according tq the first embodiment; and FIG. 21 is a view illustrating an example of separation process according to the second embodiment. As illustrated in FIG. 20, when the full cutting is performed from the front surface using a cutoff blade having a blade thickness smaller than that of the cutoff blade used for the half cutting (refer to formula (2)), the bottom part of each electronic module 100 obtained by the separation process protrudes to the outside by a cutoff portion Sd (refer to FIG. 14).

$$Wm0 > Wm1 \quad ... \quad (2)$$

Wm0; blade thickness for half cutting
Wm1; blade thickness for full cutting from the front surface

when the separation is performed by such method, the size of the electronic module 100 increases by the cutoff portion Sd. Here, in order to make the cutoff portion. Sd smaller, the blade thickness of a cutoff blade used for full cutting may be increased; but when the blade thickness is increased, the side surface of the cutoff blade may come into contact with the metal shield 120 during the cutoff, reducing the shield effect.

Thus, according to the second embodiment, as illustrated in FIG. 21, full cutting is performed from the rear surface using a cutoff blade having a blade thickness larger than that of the cutoff blade used for the half cutting (refer to formula (3)). In performing the full cutting, similarly to the half cutting, an incision is made along the reference line S from the rear surface to the half cutting position, whereby the cutoff is performed. Here, in performing the full cutting, the rear surface of the integrated multi-layer substrate 1a may be marked with an additional reference line for full cutting, so that the cutoff is performed along that reference line.

$$Wm0 > Wm2 \qquad ... \ (3)$$

Wm0; blade thickness for half cutting
Wm2; blade thickness for full cutting from the rear surface

When the electronic modules 100 are separated in this way, the bottom end 90 of each electronic module 100 is, as illustrated in FIG. 15, positioned at an inner side relative to the end of the metal shield 120. Accordingly, the size of the electronic module 100 can be set without considering the cutoff portion Sd protruding to the outside relative to the metal shield 120 as illustrated in FIG. 14, so the substantial effective area of the substrate can be increased, allowing downsizing of the module. Further, when the electronic modules 100 are separated after a connection terminal and the like have been arranged on the rear surface of the integrated multi-layer substrate 1a, also, when the full cutting is performed from the rear surface of the integrated multi-layer substrate 1a, the electronic modules can be separated without damaging the connection terminal.

In the above embodiment, there was described a case where the full cutting is performed from the rear surface using a cutoff blade having a blade thickness larger than that of the cutoff blade used for the half cutting. However, any cutoff blade can be used as long as the cutting can be performed so that the bottom end 90 of each electronic module is positioned at an inner side relative to the end of the metal shield 120.

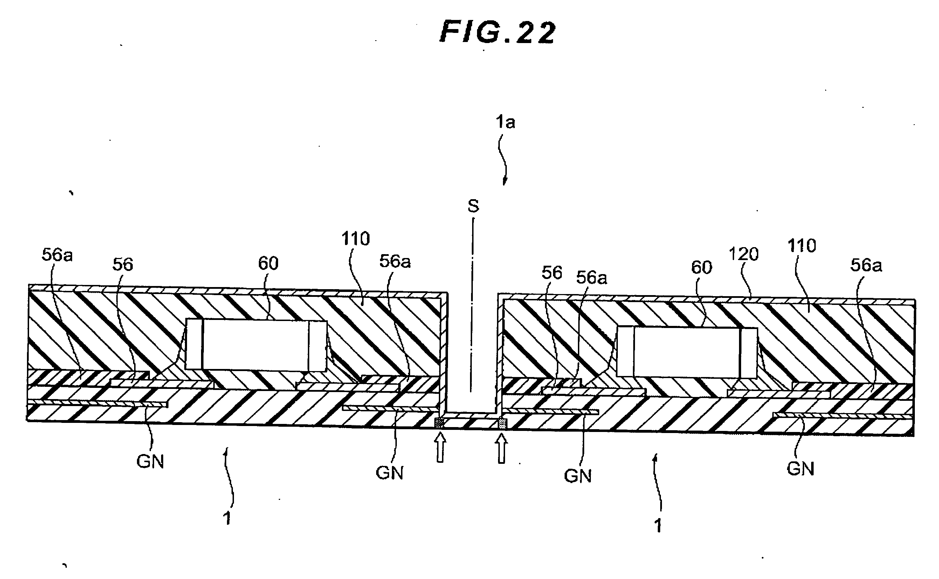

For example, even when there is used a cutoff blade having a blade thickness smaller than that of the cutoff blade used for the half cutting, when an incision is made twice from the rear surface to the half cutting position so that a part of the ground electrode GN is exposed (refer to FIG. 22), the electronic module 100 as illustrated in FIG. 15 can be provided. Further, when a special cutoff blade having a concave-shaped cross-section is used, the electronic module as illustrated in FIG. 15 can be provided by making an incision only once.

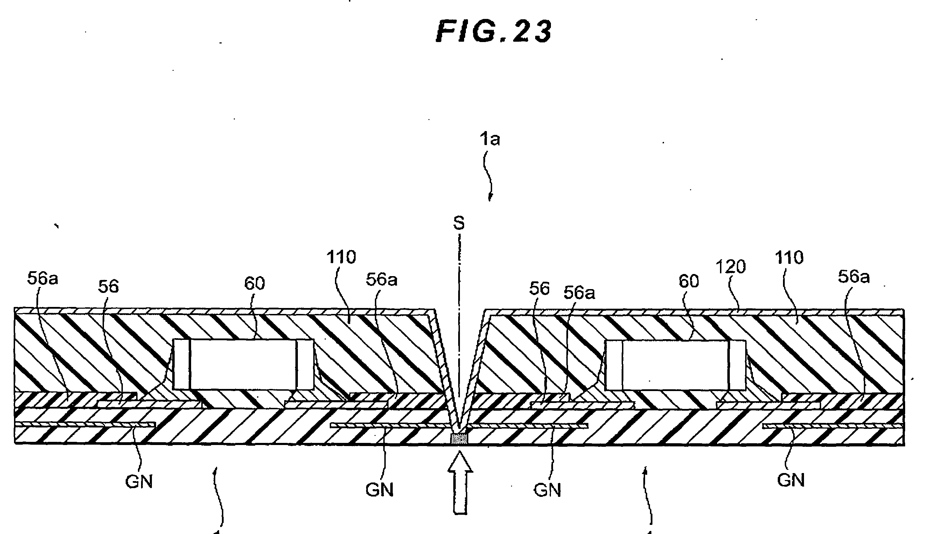

Further, in the above embodiment, the half cutting is performed so that the side surface of the exposed section of the ground electrode GN is perpendicular to a direction of the insulating layer plane (for example, refer to FIG. 21). However, similarly to the first embodiment, the half cutting may be performed so that the side surface of the exposed section of the ground electrode GN has a prescribed inclination (taper) relative to a direction perpendicular to the insulating layer (a direction perpendicular to the insulating layer plane: normal line direction), and thereafter the sealing layer 110 and metal shield 120 are formed, and finally the full cutting is performed from the rear surface (refer to FIG. 23).

As described above, according to the present invention, since the conductive shield used to shield electronic components and the ground electrode exposed on the side surface of the insulating layer are connected, the ground electrode arranged in the peripheral edge of substrate and its formation area according to the prior art can be reduced to enlarge the mounting area of electronic components, allowing further downsizing by higher mounting density; further the ground electrode and conductive shield can be reliably connected and in addition, connection failure caused by non-exposure of the ground electrode can be prevented, allowing improvement in product reliability, yield rate and productivity. Accordingly, the present invention can be applied widely and effectively to the fabrication of an apparatus, equipment, system, various types of devices or the like incorporating an active component such as a semiconductor device, and/or a passive component such as a resistor, capacitor or the like, and particularly to the fabrication of those required to be downsized and have high performance.

## Claims

1. An electronic module comprising:

    an insulating layer;
    a ground electrode arranged in the insulating layer and partly exposed from a side surface of the insulating layer;
    an electronic component mounted on the insulating layer;

a sealing layer which seals the electronic component; and
a conductive shield which covers the sealing layer and is electrically connected to the ground electrode at an exposed section of the ground electrode.

2. The electronic module according to claim 1, wherein a plurality of the ground electrodes having the exposed section are provided in a direction perpendicular to the insulating layer.

3. The electronic module according to claim 1 or 2, wherein the exposed section of the ground electrode in the side surface of the insulating layer has a inclination relative to a direction perpendicular to the insulating layer.

4. An electronic module fabrication method for fabricating a plurality of electronic modules including electronic components, the method comprising the steps of:

forming an insulating layer having a ground electrode;
mounting on the insulating layer, a plurality of electronic components included in the plurality of electronic modules;
forming on the insulating layer and the plurality of electronic components, a sealing layer which seals the plurality of electronic components;
cutting the insulating layer and the sealing layer so as to expose a part of the ground electrode from a side surface of the insulating layer;
forming a conductive shield which covers the sealing layer and is electrically connected to the ground electrode at an exposed section of the ground electrode; and
separating the plurality of electronic modules.

5. The electronic module fabrication method according to claim 4, wherein

the step of forming the insulating layer having the ground electrode includes forming the insulating layer in which the ground electrode extends at least two areas of the areas where the electronic modules are formed; and
the step of cutting the insulating layer and sealing layer includes cutting the insulating layer and sealing layer so as to define each of the areas where the electronic modules are formed and to expose a part of the ground electrode from the side surface of the insulating layer.

6. The electronic module fabrication method according to claim 4 or 5, wherein

the step of forming the insulating layer having the ground electrode includes forming the insulating layer in which a plurality of the ground electrodes in a direction perpendicular; and
the step of cutting the insulating layer and sealing layer includes carrying out the cutting so as to expose a plurality of the ground electrodes from the side surface of the insulating layer.

7. The electronic module fabrication method according to any one of claims 4 to 6, wherein the step of cutting the insulating layer and sealing layer includes carrying out the cutting so that the exposed section of the ground electrode on the side surface of the insulating layer has an inclination relative to a direction perpendicular to the insulating layer.

8. The electronic module fabrication method according to any one of claims 4 to 7,
wherein in separating the plurality of electronic modules, cutoff is carried out by making an incision from a surface opposite to the cut surface to the cut position; and
wherein in carrying out the cutoff by making an incision, the incision is made so that the bottom end of the insulating layer is positioned at an inner side relative to the end face of the conductive shield.

9. The electronic module fabrication method according to claim 8, wherein in carrying out the cutoff by making an incision, the incision is made using a cutoff blade having a blade thickness larger than that of the cutoff blade used for the cutting.

10. The electronic module according to any one of claims 1 to 3, wherein the bottom end of the insulating layer is positioned at an inner side relative to the end face of the conductive shield.

## FIG.1

## FIG.2

# FIG.3

EP 2 009 692 A1

EP 2 009 692 A1

# FIG.4

# FIG.5

EP 2 009 692 A1

# FIG.6

EP 2 009 692 A1

## FIG.7

# FIG.8

EP 2 009 692 A1

## FIG.9

## FIG.10

# FIG.11

# FIG.12

# FIG.13

# FIG.14

# FIG.15

EP 2 009 692 A1

## FIG.16

# FIG.17

# FIG.18

EP 2 009 692 A1

EP 2 009 692 A1

## FIG.19

EP 2 009 692 A1

# FIG.20

# FIG.21

EP 2 009 692 A1

# FIG.22

EP 2 009 692 A1

# FIG.23

EP 2 009 692 A1

Europäisches
Patentamt

European
Patent Office

Office européen
des brevets

## EUROPEAN SEARCH REPORT

**Application Number**

EP 08 01 1741

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | US 2006/266547 A1 (KOGA ISSEI [JP])<br>30 November 2006 (2006-11-30)<br>* paragraphs [0068] - [0078]; figures 1,2,4-9 *<br>----- | 1,4,5,<br>8-10<br>2,3,6,7 | INV.<br>H01L23/552<br>H01L25/04 |
| X | WO 2007/060784 A (MURATA MANUFACTURING CO [JP]; KAWAGISHI MAKOTO [JP]; IEKI TSUTOMU [JP]) 31 May 2007 (2007-05-31)<br>* figure 1 *<br>& US 2008/210462 A1 (KAWAGISHI MAKOTO [JP] ET AL) 4 September 2008 (2008-09-04)<br>----- | 1 | |
| Y | JP 05 014015 A (TDK CORP)<br>22 January 1993 (1993-01-22)<br>* abstract *<br>----- | 2,6 | |
| Y | JP 05 090430 A (NIPPON ELECTRIC CO)<br>9 April 1993 (1993-04-09)<br>* abstract *<br>----- | 3,7 | |
|  |  |  | TECHNICAL FIELDS SEARCHED (IPC) |
|  |  |  | H01L |

The present search report has been drawn up for all claims

| Place of search | Date of completion of the search | Examiner |
|---|---|---|
| Munich | 4 November 2008 | Cortes Rosa, João |

EPO FORM 1503 03.82 (P04C01)

**ANNEX TO THE EUROPEAN SEARCH REPORT
ON EUROPEAN PATENT APPLICATION NO.**

EP 08 01 1741

This annex lists the patent family members relating to the patent documents cited in the above-mentioned European search report.
The members are as contained in the European Patent Office EDP file on
The European Patent Office is in no way liable for these particulars which are merely given for the purpose of information.

04-11-2008

| Patent document cited in search report | | Publication date | Patent family member(s) | | Publication date |
|---|---|---|---|---|---|
| US 2006266547 | A1 | 30-11-2006 | CN | 1870857 A | 29-11-2006 |
| | | | JP | 2006332255 A | 07-12-2006 |
| WO 2007060784 | A | 31-05-2007 | US | 2008210462 A1 | 04-09-2008 |
| US 2008210462 | A1 | 04-09-2008 | WO | 2007060784 A1 | 31-05-2007 |
| JP 5014015 | A | 22-01-1993 | NONE | | |
| JP 5090430 | A | 09-04-1993 | JP | 2718299 B2 | 25-02-1998 |

EPO FORM P0459

**EP 2 009 692 A1**

REFERENCES CITED IN THE DESCRIPTION

**Patent documents cited in the description**

- JP 2007172088 A
- JP 2008153261 A
- JP 2004193187 A